Europäisches Patentamt

European Patent Office

Office européen des brevets

(19)

(11) **EP 1 471 677 A1**

(12) **EUROPEAN PATENT APPLICATION**

(43) Date of publication:
**27.10.2004 Bulletin 2004/44**

(51) Int Cl.⁷: **H04L 1/00**, H03M 13/29

(21) Application number: **03290993.9**

(22) Date of filing: **23.04.2003**

| (84) | Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK** | (72) | Inventors:<br>• **Berens, Friedbert**<br>  **1202 Geneva (CH)**<br>• **Kreiselmaier, Gerd**<br>  **67126 Hochdorf-Assenheim (DE)** |
|---|---|---|---|
| (71) | Applicants:<br>• **STMicroelectronics N.V.**<br>  **1118 BH Schiphol Airport Amsterdam (NL)**<br>• **STMicroelectronics S.A.**<br>  **92120 Montrouge (FR)** | (74) | Representative: **Zapalowicz, Francis**<br>**Bureau D.A. Casalonga-Josse,**<br>**Paul-Heyse-Strasse 33**<br>**80336 München (DE)** |

(54) **Method of blindly detecting a transport format of an incident convolutional encoded signal, and corresponding convolutional code decoder**

(57)    The actual transport format is ex ante unknown and belonging to a set of MF predetermined reference transport formats. The signal comprises a data block having an ex ante unknown number of bits corresponding to said ex ante unknown transport format, and a cyclic redundancy check (CRC) field containing a transmitted CRC word. The method comprises decoding said signal using a Maximum-a-Posteriori algorithm, said decoding step including decoding said signal considering respectively the MF possible reference formats and respectively delivering MF corresponding groups of soft output information, calculating from each group of soft output information a calculated CRC word and comparing said calculated CRC word with said transmitted CRC word, selecting all the groups for which said calculated CRC word is equal to said transmitted CRC word, and selecting the actual transport format of the encoded signal from at least one soft output information among the last ones of each selected group.

FIG.10

**Description**

The invention relates in general to channel coding and decoding techniques, especially convolutional codes, and more particularly to the blind transport format detection (BTFD).

An application of the invention is directed in general to the field of wireless communication systems, and more particularly to the CDMA systems such as the different CDMA based mobile radio systems like CDMA 2000, WCDMA (Wide Band CDMA) or the IS-95 standard.

The third generation mobile radio system specifies Convolutional codes as well as Turbo-codes as channel coding techniques [3GPP, Technical Specification Group Radio Access Network ; *Multiplexing and channel coding (FDD)* ; (3G TS 25.212 version 3.5.0(2000-12)), Release 1999].

The UMTS standard defines, beside the TFCI (Transport Format Combination Indicator) base transport format detection, a possibility of blindly detect the transport format in use. More details can be found in 3GPP, Technical Specification Group Radio Access Network; *Multiplexing and channel coding (FDD);* (3G TS 25.212 version 4.3.0 (2001-12)), Release 4.

This option is used in order to reduce the TFCI symbol overhead in the transmission frame and thus to increase the air load. Further, as indicated in the UMTS standard, the explicitly blind detected transport channels have to be coded using a convolutional code.

Generally speaking, the blind transport format detection is based in the use of the CRC (Cyclic Redundancy Check) words. An example of such detection can be found in the annex of the above mentioned 3GPP document. The main idea is to use a Viterbi decoder for decoding the different possible block sizes corresponding to the possible transport formats which can be used in the transport channel under investigation. Then, a CRC word (Cyclic Redundancy Check word), has to be checked for all possible block sizes. A correct CRC determines the correct block size. For large CRC length, the CRC check is sufficient to determine the correct block. However, in the case of smaller CRCs, like 8 or 12 bits, an additional metric has to be deployed in order to distinguish between two or more blocks with a correct CRC. And, when a Viterbi decoder is used, an additional calculation is needed for calculating this additional metric.

The invention intends to provide a solution to this problem and proposes a different method of blindly detecting a transport format of an incident convolutional encoded signal.

Generally speaking, said transport format being *ex ante* unknown and belonging to a set of MF predetermined reference transport formats, said signal comprising a data block having an ex *ante* unknown number of bits corresponding to said *ex ante* unknown transport format, and a Cyclic Redundancy Check (CRC) field, containing a transmitted CRC word, the method according to the invention comprises decoding said signal using a Maximum-a-Posteriori algorithm, said decoding step including decoding said signal considering respectively the MF possible reference formats and respectively delivering MF corresponding groups of soft output information, calculating from each group of soft output information a calculated CRC word and comparing said calculated CRC word with said transmitted CRC word, selecting all the groups for which said calculated CRC word is equal to said transmitted CRC word, and selecting the actual transport format of the encoded signal from at least one soft output information among the last ones of each selected group.

Thus, the invention uses already calculated soft output information (LLR information) as additional metric to distinguish between two or more blocks with a correct CRC. This is possible since the proposed architecture uses a MAP base decoder for decoding the CC code. In this case, no additional metric calculation is needed like in the case of the Viterbi decoder.

According to an embodiment of the invention, the actual transport format of the encoded signal is selected from the last soft output information of each selected group.

The actual transport format is for example the reference format having the greatest last soft output information.

However, other possibilities exist for selecting the actual transport format. For example, we can use the last but one soft output information, or the last but one and the last soft output information. Another possibility consists in combining one of the last soft output information with the minimum soft output information.

According to an embodiment of the invention, said decoding step comprises calculating state metrics, and all the data blocks are decoded in parallel window-by-window on sliding windows having a predetermined size, and at least some of the states metrics calculated on a window are valid for all the data blocks.

According to a preferred embodiment of the invention, said decoding step comprises for each window calculating forward state metrics during a forward recursion, performing a backward acquisition having a predetermined acquisition length, calculating backward state metrics during a backward recursion and calculating soft output information in the reverse order, and for each window only one forward recursion is performed which is valid for all the transport formats.

According to an embodiment of the invention, the first window processing including forward recursion, backward acquisition, backward recursion and soft output calculation, is completely valid for all data blocks having a size larger than the sum of the window size and the acquisition length.

In other words, according to particular embodiments of the invention, there is a complete reuse of forward state metric calculation for all different block sizes and partial reuse (if possible) of backward state metric calculation and LLR calculation for different block sizes.

The invention proposes also a convolutional code decoder, comprising

- input means for receiving an convolutional encoded signal having an ex ante unknown transport format belonging to a set of MF predetermined reference transport formats, said signal comprising a data block having an ex ante unknown number of bits corresponding to said ex ante unknown transport format, and a Cyclic Redundancy Check (CRC) field containing a transmitted CRC word,
- convolutional code decoding means implementing a Maximum-a-Posteriori algorithm for decoding successively said signal by considering respectively successively the MF possible reference formats and comprising a Log-Likelihood-Ratio unit for successively respectively delivering MF corresponding groups of soft output information,
- blind transport format detection means comprising a Cyclic Redundancy Check unit for calculating from each group of soft output information a calculated CRC word and comparison means for comparing said calculated CRC word with said transmitted CRC word, first selection means for selecting all the groups for which said calculated CRC word is equal to said transmitted CRC word, and second selection means for selecting the actual transport format of the encoded signal from at least one soft output information among the last ones of each selected group.

According to an embodiment of the invention, said second selection means are adapted to select the actual transport format of the encoded signal from the last soft output information of each selected group.

According to an embodiment of the invention, said convolutional code decoding means are adapted to calculate state metrics, all the data blocks are decoded in parallel window-by-window on sliding windows having a predetermined size, and at least some of the state metrics calculated on a window are valid for all the data blocks.

According to an embodiment of the invention, said convolutional code decoding means are adapted for each window, to calculate forward state metrics during a forward recursion, to perform a backward acquisition having a predetermined acquisition length, to calculate backward state metrics during a backward recursion, and for each window only one forward recursion is performed which is valid for all the transport formats.

According to an embodiment of the invention, the first window processing including forward recursion, backward acquisition, backward recursion and soft output calculation, is completely valid for all data blocks having a size larger than the sum of the window size and the acquisition length.

The code decoder according to the invention can be a combined Turbo-code/convolutional code decoder further comprising Turbo-code decoding means for performing Turbo-code decoding.

And, according to an embodiment of the invention, said Turbo-code and convolutional code decoding means comprises common processing means having a first configuration dedicated to Turbo-code decoding and a second configuration dedicated to convolutional code decoding. And said decoder further comprises :

- metrics memory means for storing state metrics associated to the states of a first trellis and delivered by said processing means in its first configuration,
- input/output memory means for storing input and output data delivered to and by said processing means in its second configuration,
- adaptable memory means for storing input and output data delivered to and by said processing means in its first configuration, and for storing state metrics associated to the states of a second trellis and delivered by said processing means in its second configuration,
- control means for configurating said common processing means in its first or second configuration depending on the kind of code, and
- memory control means for addressing differently said adaptable memory means depending on the configuration of said common processing means.

Said common processing means may implement a Maximum-A posteriori (MAP) algorithm.

And, the MAP algorithm implemented is for example a so-called LogMAP algorithm or a so-called MaxLogMAP algorithm.

The convolutional code decoder according to the invention may be advantageously realized by an integrated circuit.

The invention proposes also a terminal of a wireless communication system including a decoder as defined above.

This terminal may form a cellular phone or a base station.

Other advantages and features of the invention will appear on examining the detailed description of embodiments, these being in no way limiting and of the appended drawings in which :

- figure 1 shows the structure of the two different NSC used in UMTS for Convolutional encoding,
- figure 2 shows a part of a trellis which represents the possible transitions in one time step,
- figure 3 shows a receiving chain of mobile phone including a decoder according to the invention,
- figure 4 shows very diagrammatically the internal structure of a first embodiment of a decoder according to the invention,
- figure 5 shows more in detail a part of a decoder according to the invention,
- figure 6 illustrates diagrammatically possible transport formats,
- figure 7 shows diagrammatically a part of blind detection means according to the invention,
- figure 8 shows diagrammatically a CRC processing scheme according to the invention,
- figure 9 shows diagrammatically a windowing scheme according to the invention,
- figure 10 illustrates a flow chart of a blind detection according to the invention,
- figure 11 shows an UMTS Turbo-code encoder,
- figure 12 shows a generic Turbo decoder,
- figure 13 shows very diagrammatically the internal structure of a decoder according to a second embodiment of the invention,
- figure 14 shows more in detail a part of the decoder illustrated in figure 13,
- figure 15 shows more in detail an adaptable memory belonging to a decoder according to the invention,
- figure 16 shows diagrammatically an ACS unit architecture,
- figure 17 shows an LLR unit belonging to a combined decoder according to the invention,
- figure 18 shows global control steps for Turbo-code decoding according to the invention.

## 1 Encoding

### 1.1 General Considerations and Convolutional encoding

Convolutional encoding is performed by calculating the modulo-2 sum of the input values of the current and/ or selected previous time steps. Implementation therefore is straightforward and mainly consists of shift register and a couple of exclusive-OR gates. Through the way those are switched, different kinds of convolutional codes can be realized:

Systematic Codes: One of the output streams is equal to the input stream, the systematic information.
Non-Systematic Codes (NSC): Each output is a parity information. Parity information is produced by taking the modulo-2 sum of shift register entries stating the history of the encoding process.
Recursive Codes: A special parity signal is produced and fed back in conjunction with the systematic input.
Non-Recursive Codes: No such feedback loop exists.

An instance of a convolutional encoder is defined by a combination of these properties, the memory depth (constraint length) and the logical functions used to produce the parity information. These properties are described through generator polynomials.

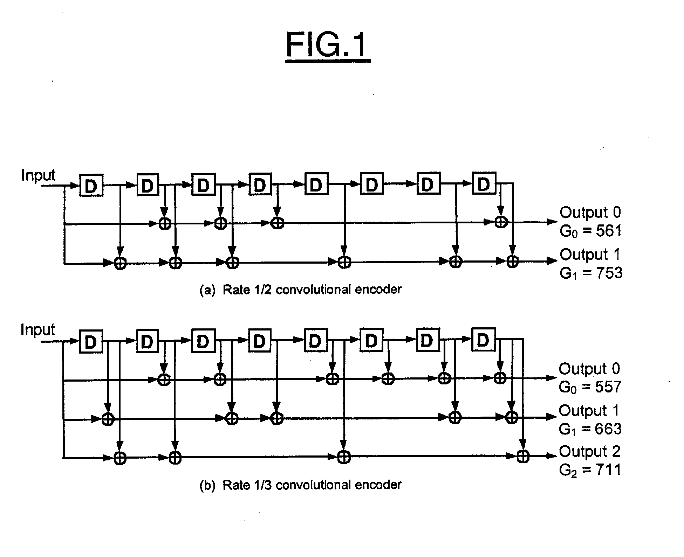

Figure 1 represents the structure of two different NSC used in UMTS for Convolution and Convolutional encoding. Furthermore, two different rates have to be considered. The rate 1/2 convolutional encoder (a) has two outputs, whereas the rate 1/3 encoder (b) has three outputs.
With the value of the current time-step available, M = K-1 flip-flops are needed to store the encoder history. This gives rise to an interpretation of the encoder as finite-state machine (FSM). It shows a behavior equivalent to a Mealy-automaton. The likelihood of a transition between two states is the key to the decoding of convolutional codes.

### 1.2 Code-Trellis

A code trellis is the unrolled state chart of a finite-state machine. The number of states the encoder can be in (N) is a function of the constraint length K:

$$N = 2^{K-1}.$$

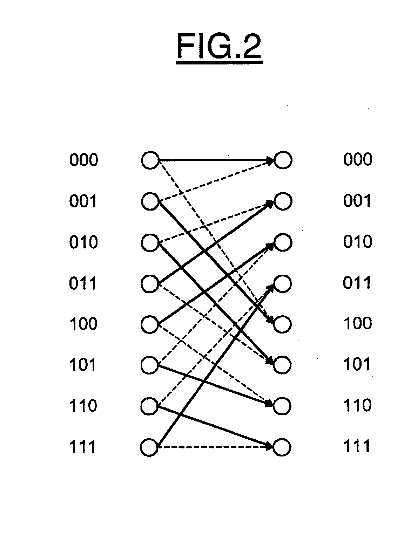

Depending on the nature of the code (RSC, NSC,...) only certain transitions are possible. A trellis is used to depict those transitions. In figure 2, a part of a trellis is shown, that represents the possible transitions in one time-step.

Instead of the usual tree-structure used to display state-charts, the trellis combines states which are equivalent. Solid lines in figure 2 stand for transitions due to the input of a systematic bit of "0" whereas dashed lines represent those caused by a "1".

On convention, every encoding process starts in the all-zero state.

## 1.3 Trellis-termination

For the considered codes the initial state of the trellis is always known to be the all-zero state. Without taking any precautions, the encoder ends in an arbitrary state, leaving no hint where to start the backward recursion. This can be counteracted by driving the encoder into a defined final state. Reaching the final state (e.g. the all-zero state) can be achieved by appending a sequence, which steers the encoder towards the final state as fast as possible. This sequence is also depending on the state the encoder is in after the last information bit has been coded. The length of this sequence is equal to K-1; the transmitted bits are called tailbits.

## 2. Decoding

2.1 Decoding convolutional codes is keeping track of the transitions that took place in the encoder. From those the input symbols which have been sent are deducted. Due to the degradations caused by the channel, only estimates of the systematic and parity bits are available, which will both be called channel values here. There are two different kinds of outputs:

Hard values: they merely indicate if a symbol is supposed to be "1" or "0".
Soft values: These also deliver a measure for the reliability of the decision (the hard decision is extend by the probability that the decision is correct).

Based on the channel values, probabilities can be computed that certain combinations of systematic and parity bit occurred. From this and considering the encoder history, the probability that the encoder was in a given state at a given time-step can be computed.

Two approaches exist to deal with those state-probabilities. The maximum likelihood based Viterbi algorithm uses them to search the most likely code-word. For this it traverses the trellis from the all-zero state to the end state and looks for the most likely sequence. The states chosen for the survivor path indicate the most likely sequence of symbols that has been send. Hence a Viterbi Decoder is a sequence estimator.

The maximum-$\alpha$-posteriori (MAP) algorithm on the other side estimates the probability that the encoder was in the given state and that the current state leads to the final state given the remainder of the channel values. This can be efficient computed by a forward and backward recursion over the trellis. Afterwards, for each bit the probabilities for those states associated with a systematic "0" are added and compared to those associated with a "1". The symbol with the higher probability is assumed to be the sent one. As this works on bit rather than on sequence level, it is called symbol estimation.

## 2.2 The maximum-A-Posteriori (MAP) Algorithm

The name Maximum-A-Posteriori stems from the fact that the estimation of the bits is based on the whole receiver sequence. It is done after all the information is in.

Equation 2.1 shows the output of such a MAP decoder.

Bahl et al. described in [L. Bahl, J. Cocke, F. Jelinek, and J. Raviv. Optimal Decoding of Linear Codes for Minimizing Symbol Error Rate. *IEEE Transaction on Information Theory,* IT-20:284-287, march 1974] an efficient algorithm for the MAP decoder, which is based on recursions operating on the trellis in forward and backward recursion. That algorithm is commonly referred to as MAP or BCJR algorithm:

Let $R_k$ denote the input of the MAP, with $\bar{R} = (R_1,...,R_k,...R_N)$ where N is the length of the block, then the BCJR-algorithm computes the a-posteriori probabilities (APP)

$$\Lambda(d_k) = \ln \frac{\Pr\{d_k = 1 \mid \bar{R}\}}{\Pr\{d_k = 0 \mid \bar{R}\}} \qquad (2.1)$$

for each data symbol $d_k$ after reception of the symbol sequence $\bar{R}$.

It is computed using two probabilities: One, that the encoder has reached state $S_k^m$, with

$$m \in \left\{ ...2^M \right\}$$

after k received symbols:

$$\alpha_k(m) = \Pr\left\{ S_k^m \mid R_0...R_{k-1} \right\} \qquad (2.2)$$

and another, that the remainder of the input sequence will lead the encoder to the final state given the state $S_{k+1}^{m'}$ at time k+1:

$$\beta_{k+1}(m') = \Pr\left\{ R_k...R_N \mid S_{k+1}^{m'} \right\} \qquad (2.3)$$

For this, the probability of a transition from state $S_k^m$ to $S_{k+1}^{m'}$ has to be known. It is depending on the code structure, the channel model and the received symbols $R_k$:

$$\gamma(S_k^m, S_{k+1}^{m'}) = \Pr\left\{ S_k^m, S_{k+1}^{m'} \mid R_k \right\} \qquad (2.4)$$

Using γ, α and β can be computed recursively by:

$$\alpha_k(m') = \sum_m a_{k-1}(m) \cdot \gamma(S_{k-1}^m, S_k^{m'}) \qquad (2.5)$$

$$\beta_k(m) = \sum_m \beta_{k+1}(m') \cdot \gamma(S_{k-1}^m, S_k^{m'}) \qquad (2.6)$$

A known start and final state are necessary for the BCJR algorithm to perform optimally. If the trellis is not terminated, all states have to be assumed to have equal probability for k = N.
The a-posteriori probability itself can be expressed as

$$\Lambda(d_k) = \ln \frac{\sum_m \sum_{m'} \gamma(S_{k-1}^m, S_k^{m'}, d_k = 1) \cdot \alpha_{k-1}(m) \cdot \beta_k(m')}{\sum_m \sum_{m'} \gamma(S_{k-1}^m, S_k^{m'}, d_k = 0) \cdot \alpha_{k-1}(m) \cdot \beta_k(m')} \qquad (2.7)$$

When the constituent encoder is a NSC, this equation can be simplified because the state number can be used to identify a state reached by input $d_k = 1$ or $d_k = 0$.

$$\Lambda(d_k) = \frac{\sum_{S_k^m \mid d_k = 1} \alpha_k(S_k^m) \cdot \beta_k(S_k^m)}{\sum_{S_k^m \mid d_k = 0} \alpha_k(S_k^m) \cdot \beta_k(S_k^m)} \qquad (2.7a)$$

The large number of multiplications involved in the computation of the APP makes it less attractive for implementation. Therefore the MAP algorithm has to be transformed to the logarithmic domain, where it becomes the Log-MAP algorithm, which increases numerical stability and eases implementation, while not degrading the error correction performance.

2.3 The MAP algorithm in the logarithm domain : LogMAP

The transformation of multiplications into additions is the motivation for defining the MAP algorithm in the Log-Domain. A problem is posed by the additions. Using the Jacobian logarithm, the additions are substituted by a new operator:

$$\ln(e^{\delta 1} + e^{\delta 2}) = \max^* (\delta 1, \delta 2) = \max(\delta 1, \delta 2) + \ln(1 + e^{-|\delta 1 - \delta 2|})$$

Similar the negative logarithm can be taken, this leads to

$$\min^* (\delta 1, \delta 2) = \min(\delta 1, \delta 2) - \ln(1 + e^{-|\delta 1 - \delta 2|}) \ .$$

For more than two operands, the max* is applied recursively. Since the operator is associative, a tree-like evaluation can be employed, which is advantageous for hardware implementation. The sub-optimal MaxLogMAP algorithm is obtained by using the approximation

$$\max^* (\delta 1, \delta 2) \approx \max(\delta 1, \delta 2) \ .$$

Using the max* operation, the recursions become:

$$\ln(\alpha_k (m')) = \max_m^* (\ln(\alpha_{k-1} (m)) + \ln(\gamma(S_{k-1}^m, S_k^{m'}))), \tag{2.8}$$

$$\ln(\beta_k (m)) = \max_m^* (\ln(\beta_{k+1} (m')) + \ln(\gamma(S_k^m, S_{k+1}^{m'}))) \tag{2.9}$$

Let $\ln(\alpha_k(m'))$ from now on be denoted as $\bar{\alpha}_k(m')$ (accordingly for $\beta$ and $\gamma$), then the recursions take the form:

$$\overline{\alpha}_k (m') = \max_m^* (\bar{\alpha}_{k-1}(m) + \bar{\gamma} (S_{k-1}^m, S_k^{m'}) \tag{2.10}$$

$$\overline{\beta}_k(m) = \max_m^*(\bar{\beta}_{k+1}(m') + \bar{\gamma}(S_k^m, S_{k+1}^{m'}). \tag{2.11}$$

Similar we get:

$$\Lambda(d_k) = \max_{m,m'}^* (\bar{\gamma}(S_{k-1}^m, S_{k-1}^{m'}, S_k^m, d_k = 1) + \bar{\alpha}_{k-1}(m) + \overline{\beta}_k(m'))$$

$$- \max_{m,m'}^* (\bar{\gamma}(S_{k-1}^m, S_k^m, d_k = 0) + \bar{\alpha}_{k-1} (m) + \overline{\beta}_k (m')) \tag{2.12}$$

and in case of an NSC encoder:

$$\Lambda(d_k) = \max_{S_k^m |d_k = 1}^* (\bar{\alpha}_k(S_k^m) + \overline{\beta}_k(S_k^m))$$
$$- \max_{S_k^m |d_k = 0}^* (\bar{\alpha}_k(S_k^m) + \overline{\beta}_k(S_k^m)) \tag{2.12a}$$

Computation $\bar{\gamma}$ of includes the estimation of channel values. An optimised branch metric calculation is used. In case of an NSC encoder the channel values are parity informations. Dependant on the rate there are only four resp. eight different values per k in total the $\bar{\gamma}$ can take. The code-structure alone determines, which of them is assigned to which transition. After skipping constant factors and making additional algebraic transformations we get (eq. 2.13) :

Rate 1/2:

$$\tilde{\gamma}(x_k^{G0} = +1, x_k^{G1} = +1) = 0$$

$$\tilde{\gamma}(x_k^{G0} = +1, x_k^{G1} = -1) = \frac{4E_s y_k^{G1}}{N_0}$$

$$\tilde{\gamma}(x_k^{G0} = -1, x_k^{G1} = +1) = \frac{4E_s y_k^{G0}}{N_0}$$

$$\tilde{\gamma}(x_k^{G0} = -1, x_k^{G1} = -1) = \frac{4E_s y_k^{G0}}{N_0} + \frac{4E_s y_k^{G0}}{N_0}$$

Rate 1/3:

$$\tilde{\gamma}(x_k^{G0} = +1, x_k^{G1} = +1, x_k^{G2} = +1) = 0$$

$$\tilde{\gamma}(x_k^{G0} = +1, x_k^{G1} = +1, x_k^{G2} = -1) = \frac{4E_s y_k^{G2}}{N_0}$$

$$\tilde{\gamma}(x_k^{G0} = +1, x_k^{G1} = -1, x_k^{G2} = +1) = \frac{4E_s y_k^{G1}}{N_0}$$

$$\tilde{\gamma}(x_k^{G0} = +1, x_k^{G1} = -1, x_k^{G2} = -1) = \frac{4E_s y_k^{G1}}{N_0} + \frac{4E_s y_k^{G2}}{N_0}$$

$$\tilde{\gamma}(x_k^{G0} = -1, x_k^{G1} = +1, x_k^{G2} = +1) = \frac{4E_s y_k^{G0}}{N_0}$$

$$\tilde{\gamma}(x_k^{G0} = -1, x_k^{G1} = +1, x_k^{G2} = -1) = \frac{4E_s y_k^{G0}}{N_0} + \frac{4E_s y_k^{G2}}{N_0}$$

$$\tilde{\gamma}(x_k^{G0} = -1, x_k^{G1} = -1, x_k^{G2} = +1) = \frac{4E_s y_k^{G0}}{N_0} + \frac{4E_s y_k^{G1}}{N_0}$$

$$\tilde{\gamma}(x_k^{G0} = -1, x_k^{G1} = -1, x_k^{G2} = -1) = \frac{4E_s y_k^{G0}}{N_0} + \frac{4E_s y_k^{G2}}{N_0}$$

This simplifies the implementation significantly, as only up to four terms have to be computed from the channel data. One term can be dropped completely and the last one be computed from two others. The scaling factor $\frac{4E_s}{N_0}$ is multiplied externally by usage of a working point.

### 3. **Windowing**

The MAP algorithm minimizes the probability of bit-errors, basing the decision for each bit on the knowledge of the complete block of samples, that is a posteriori. It has been shown, however, that a sliding window technique, where a window slides in direction of increasing bit positions k, delivers almost the same communication performance as the original MAP decoder. Then the decisions are based on a subblock beginning at the first bit position in the complete block and ending at the last position in the sliding window. The MAP algorithm can decide all bits belonging to the window, less the bits contained in the last portion of that window. Those bits in the last portion are decided when the window has moved to its next position(s). If only the bits in the middle part get decoded, then the window does not even have to slide (that is to move steadily in one direction).

When we look at the equations of the MAP algorithm, one can easily identify four subtasks:

Calculation of the branch metrics (step 1)
Calculation of the forward state metrics during forward recursion (step 2)
Calculation of the backward state metrics during backward recursion (step 3)
Calculation of the soft outputs (step 4)

The data dependencies between these steps are as follows: both recursions (step 2 and step 3) and the soft output calculation (step 4) depend on the branch metrics (step 1), and the soft output calculation step (step 4) in addition depends on the forward and backward state metrics (step 2 and step 3). All branch metrics and soft outputs of the current data block can be computed independently from each other. Only the order of computing the forward state metrics and the order of computing the backward state metrics are predefined by the direction of the respective recursion. The sequence of the recursions does not matter, since there is no data dependency between the forward and backward state metrics. The backward recursion can be processed before, in parallel to, or after (as implied above) the forward recursion. Hence, we can introduce the notion of a first and a second recursion. The metrics for the first recursion for a certain trellis step have to be stored in memory until the second recursion has produced the missing complementary metrics for computing the soft output value connected with that trellis step. Thus the decoder needs to store the first recursion metrics of the full data block. Introducing windowing, each comprising a data subblock, breaks this dependency. Decoding on a window-by-window basis permits to reduce the required memory size.

A prerequisite for decoding on windows is the concept of "acquisition". Originally, the forward and the backward recursion of a MAP decoder start at one end of the trellis and stop at the opposite end. Upon an appropriately long acquisition phase, however, a recursion can start at any trellis step. This applies to both forward and backward recursions.

Consider a forward acquisition commencing at trellis step k-M, where M is the acquisition depth. The forward state metrics are initialized as:

$$\overline{\alpha}_{k-M}(S_{k-M}) = 0, \quad S_{k-M} \in \left\{0,...,2^m - 1\right\} \qquad (3.1)$$

After M recursion steps, the metrics $\bar{\alpha}_k(S_k)$ approach the values that would be obtained by starting the recursion from the beginning of the trellis. Now consider a backward recursion commencing at trellis step k+M. The backward state metrics are initialized as:

$$\overline{\beta}_{k+M}(S_{k+M}) = 0, \quad S_{k+M} \in \left\{0,...,2^m - 1\right\} \qquad (3.2)$$

In analogy to the forward recursion, after the same number of recursion steps M, the metrics $\bar{\beta}_k(S_k)$ approach the values that would be obtained by starting the recursion at the end of the trellis. If the acquisition depth M is too small, then the decoding performance can be severely degraded. With M above a certain value, the decoding performance is virtually optimal. The value of M that leads to a reasonable balance between computational effort and decoding performance can be determined by simulation.

The windowsize itself has no influence on the communication performance, but on the size of the RAM for storage of the $\alpha$-state metrics. Furthermore the throughput is dependant on the ratio between acquisition length and windowsize. When only one state metric calculation unit is available, the individual windows are processed sequential. It takes one clock cycle for the forward recursion and one clock cycle for the backward recursion/LLR calculation per data bit. The additional computational overhead is determined by the total number of acquisition steps. If the windowsize is equal to the acquisition length, the decoding needs one additional clock cycle per bit, resulting in total three clock cycles per bit. If the windowsize is much larger than the acquisition length, the computational overhead goes near zero, resulting in a throughput of nearly two. So the choice of the windowsize is a trade off between memory size and throughput.

**4. First embodiment of a convolutional decoder.**

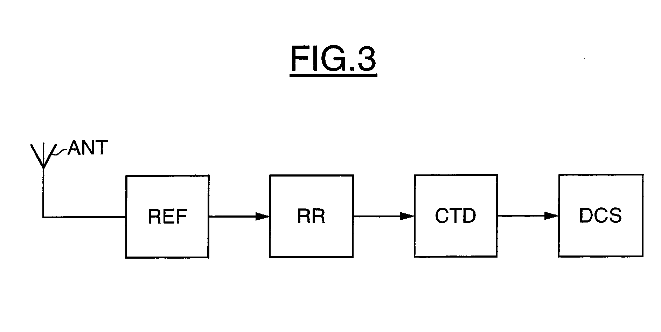

4.1 We refer now to figure 3 which illustrates a decoder according to the invention which is incorporated in the reception chain of a cellular mobile phone TP.

The encoded signal is being received by the antenna ANT and processed by the radio frequency stage ERF of the receiver. At the output of the ERF stage, the signal is converted into the digital domain by an A/D converter. The digital base band signal is then processed by a "rake" demodulator which is used generally in the case of a CDMA system.

Then, the channel decoding stage includes a convolutional code decoder CTD according to the invention.

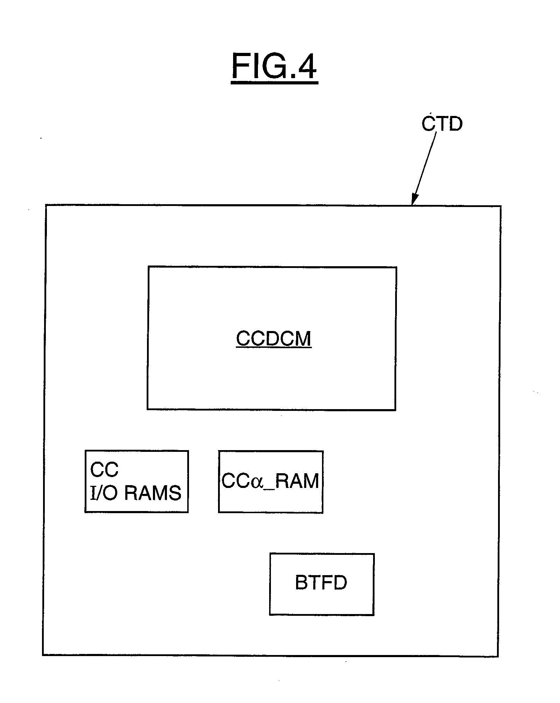

The decoder CTD according to the invention, as illustrated on figure 4, comprises convolutional code decoding means CCDCM for performing convolutional code decoding.

The decoding means CCDCM implements a MAP algorithm.

Further, input/output memory means referenced as CC I/O RAMs are provided for storing input and output data delivered to and by the decoding means CCDCM.

Further, another memory, referenced CC$\alpha$-RAM, is used for storing forward state metrics ($\alpha$-state metrics) associated to the states of a trellis (for example 256 states) and delivered by the decoding means CCDCM.

At last, the decoder CCD comprises blind transport format detection means BTFD for blindly detecting the transport format used in a transport channel under investigation. The internal architecture of these means BTFD will be described more in detail thereafter.

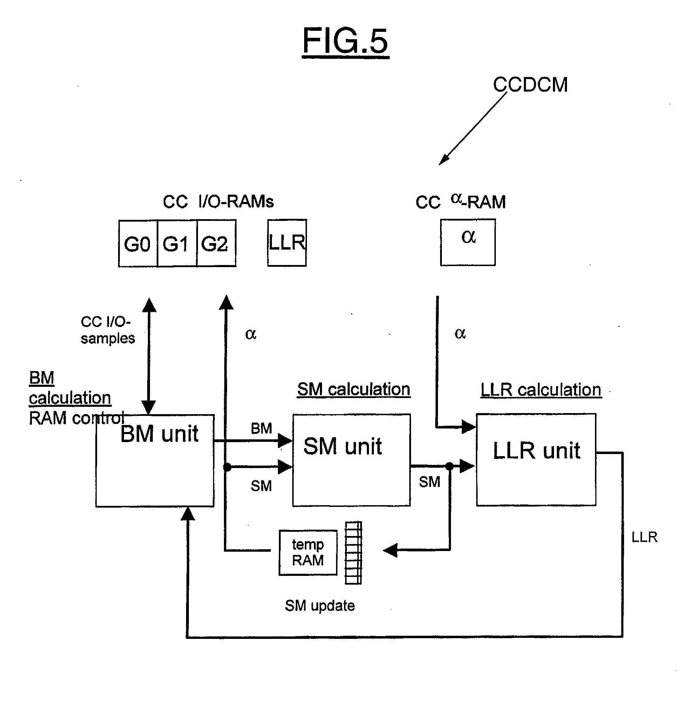

Figure 5 illustrates more in detail internal structure of the convolutional code decoding means CCDCM.

These means comprise essentially three major calculation units, i.e. :

- a BM unit that calculates the branch metrics BM and controls the CC I/O RAMs. The calculation of the branch metrics is performed according to equation 2.13, depending on the value of the rate,
- the state metric unit SM which calculates state metrics SM according to equations 2.10 and 2.11,
- the LLR unit, which calculates the soft output information (LLRs) in a pipeline manner, according to equations 2.12a.

The input RAMs consist in three RAMs referenced as GO-RAM, G1-RAM and G2-RAM according to the respective convolutional code input data. Output RAM is a LLR-RAM.

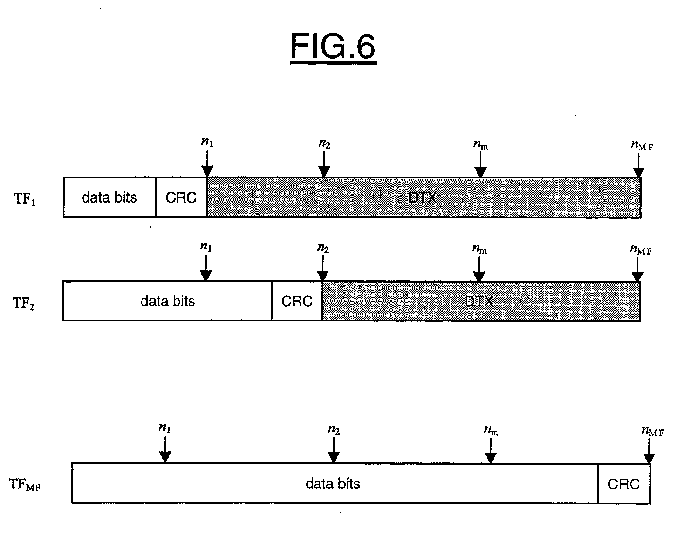

The blind detection of the transport format will be now described more in detail with reference to figures 6-10.

In figure 6, the structure of a coded block in the case of BTFD is depicted.

The transport channel under consideration has MF different transport formats $TF_1$ to $TF_{MF}$ and thus MF different coded blocks sizes. A coded block contains a CRC field (transmitted CRC word) and the data bit field. The CRC field in each of the different blocks has the same size and thus uses the same polynomial. In the presented case the coded block only contains one CRC at the end. The DTX field can be considered as being noise.

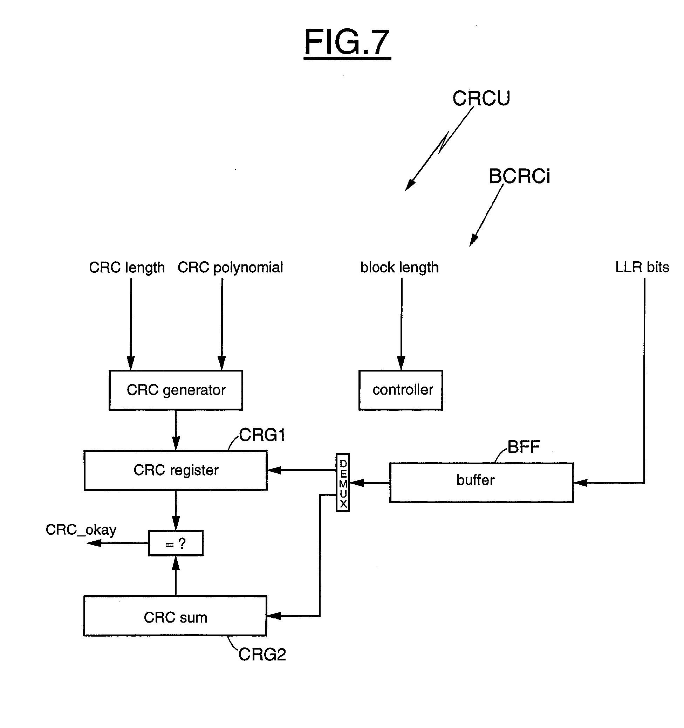

The blind transport format detection means comprises a Cyclic Redundancy Check Unit CRCU (figure 7) for calculating from each group of soft output information (LLR) corresponding to each transport format, a calculated CRC word. This calculated CRC word is stored in a CRC register CRG1. Therefore, certain input parameters are necessary, which are the length of the CRC and the CRC polynomials.

The transmitted CRC word (CRC sum) which is attached to the data block in reverse order during the encoding, is stored in the register CRG2.

Comparison means are adapted to compare the content of the register CRG1 with the register CRG2. When equal, the CRC check is positive.

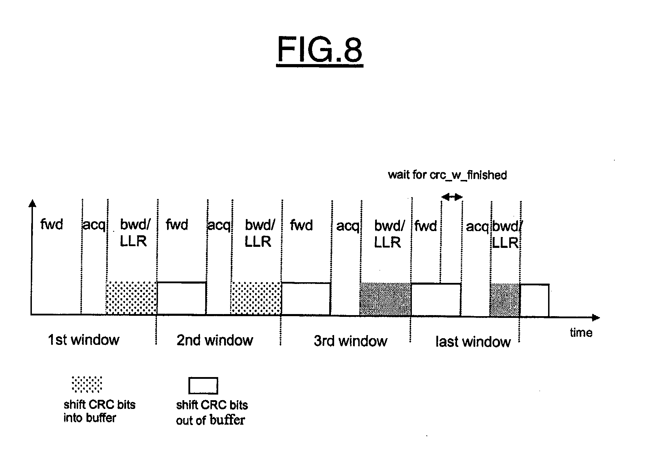

The LLR bits are stored in a buffer BFF of windowsize (for example 53 bits for convolutional code). These bits are shifted out of the buffer into the register CRG1 during forward recursion and backward acquisition (figure 8).

This architecture can be extended to check up to MF=16 different block sizes by usage of total 16 CRC check units. The buffer has to be implemented only once, because the LLRs of the different blocks are calculated serially. So only the shaded blocks in figure 7 are multiple instantiated.

As mentioned before, a sliding window approach is used. The MAP algorithm minimizes the probability of bit-errors, basing the decision for each bit on the knowledge of the complete block. Originally the forward and backward recursion of a MAP decoder start at one end of the trellis and stop at the opposite end. This starting points are known for the forward recursion (state 0) and if tailing is applied as in UMTS, we also know the end point (= starting point for backward recursion) of the trellis (state 0). However upon an appropriate long acquisition phase we can start at any trellis step. This applies for both forward and backward recursion. The starting point for the forward recursion is always known, because we start the calculation with the alpha recursion. Furthermore the starting points for the following window is known, because we already calculated the state metrics and stored them in the alpha RAM. For backward recursion we need acquisition to get the appropriate starting points when calculating the backward recursion for the window. So we normally do the normal (full) acquisition to initialize the backward recursion. This is done until we get to the last two windows. These windows are somewhat special:

- last window: We don't do a normal acquisition, because we don't have data to do so. But we don't need this at all, because we have the tailbits, which are used to give us the init state metrics for backward recursion.
- last but one window: It could happen, that there are not enough data bits left to do a full acquisition. But this is no problem because we simply start with the tail bits and then process the remaining acquisition steps. Than we proceed as usual with backward recursion/LLR calculation.

It would be possible to adapt this scheme for the blind transport format detection. However, if we consider for example two transport formats of sizes 108 and 120, then, when we determine the LLRs for block length 108, we cannot calculate the LLRs for block length 120 without starting the forward recursion from the second window. And the initialization values for the forward recursion have to be stored in specific memory, otherwise, we have to start the forward recursion from the beginning.

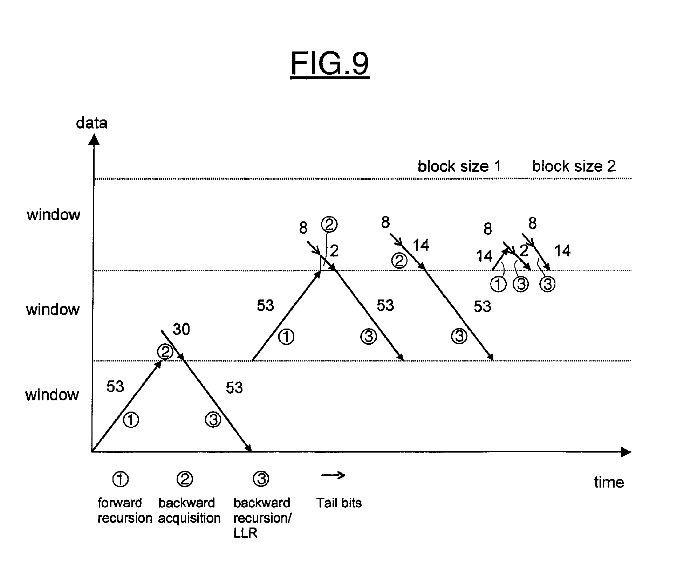

When one wants to reuse as much as possible, the calculation scheme has to be preferably changed. The individual block lengths are not calculated serially, but in parallel. This is shown in figure 9. The actual stored alpha values are used for calculating all possible LLRs of this window. This way, we have only one forward recursion for all the different transport formats, only the backward recursion/LLR calculation is individual. Furthermore even some backward recursion/LLR calculations are done only once for more than one block size. So we have a total reuse of all so far calculated alpha values and the possibility of partial reuse of calculated beta values and LLRs. As there can be more than one block length with correct CRC, the absolute values of the last LLR can be used to distinguish between two or more blocks with a correct CRC. These values have to be stored additionally.

Figure 9 shows the windowing scheme for the already mentioned example for two different block sizes 108 and 120. The processing starts with forward recursion for the first window. After the backward acquisition the backward recursion/LLR calculation follows. The forward recursion is only done once, the alpha state metrics are valid for both block sizes. Because the second block size is larger than the sum (window size+acquisition length), the backward recursion/LLR calculation is valid for both blocks. So the first window processing (forward recursion, backward acquisition, backward recursion/LLR calculation) is completely reused for both block sizes.

The next window starts as usual with forward recursion. Because this is the last but one window for the first block size (108) in this example, there is no full acquisition but the tail bit processing and a partial acquisition. Afterwards the backward recursion/LLR calculation for the second window follows. These calculated LLRs are individual for the first block size and can't be reused. So for the second block size a separate backward acquisition and backward recursion/LLR calculation has to be performed. In our example the acquisition also consists of tail bits and partial acquisition.

The next window starts with the forward recursion. The forward recursion is always done for the whole data, so it is either a complete window or for the last window consists of the remaining bits. So in our example it is done for the remaining 14 bits. Then the last backward processing for block size 108 starts with the acquisition (done with tail bits) and then the backward recursion/LLR calculation. After all LLRs for block size 108 are calculated the results of the final CRC is available. The last backward processing for block size 120 is done similar.

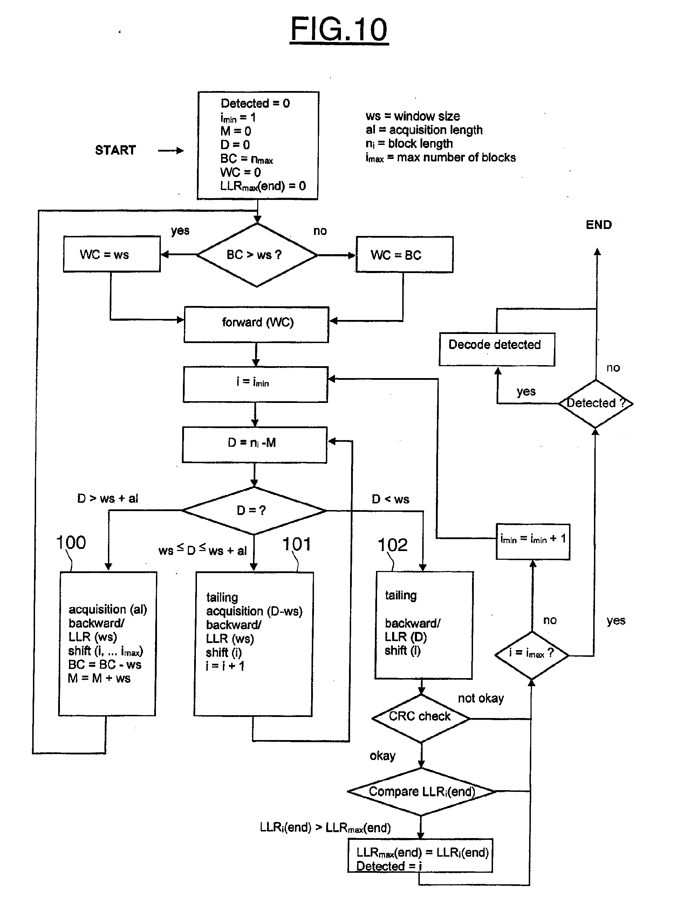

The proposed general processing flow for BTFD is shown in figure 10.

In step 100, "shift $(i,...i_{max})$" means that the calculated LLR bits are stored in all the CRC registers CRG1 respectively associated with all the possible formats $(i_{min}...i_{max})$. However, in steps 101 and 102, "shift(i)" means that the LLR bits are stored in the CRC register associated to the current format i.

### 5. Second embodiment of a convolutional decoder

A second embodiment of a decoder according to the invention will be now described. This decoder is a combined Turbo-code/convolutional code decoder, as for example the one which has been disclosed in European patent application n° 0 201 9974.1.

The main features of such a combined decoder will be now described.

However, before describing in detail the internal architecture of such combined decoder, some general considerations on Turbo-code encoding and decoding will be now described.

5.1 A Turbo code encoder consists of two constituent convolutional encoders and an interleaver. The convolutional codes are fixed to be the RSC codes of rate 1/2 and generator polynomials (13,15/(octal notation) introduced before.

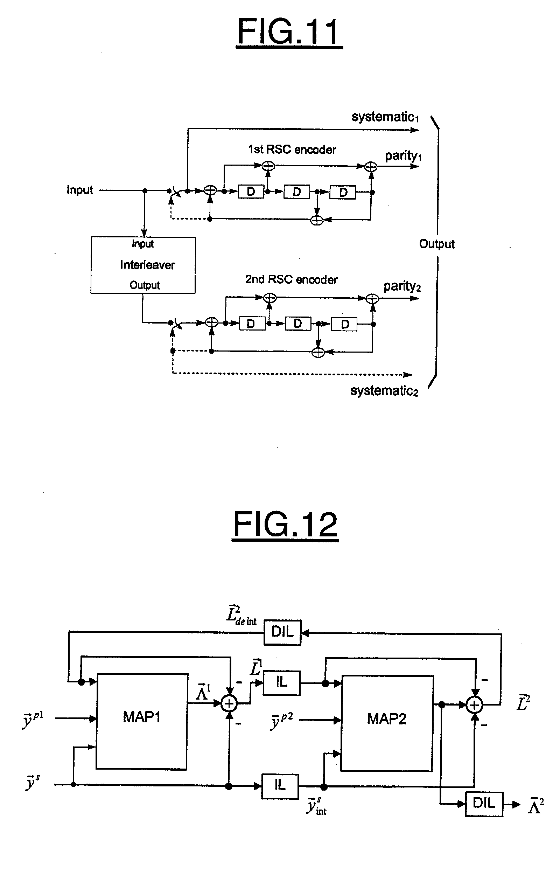

The systematic information of the second encoder is not transmitted because it can be reconstructed (by deinterleaving) from the systematic output of the first encoder. By this a rate of R = 1/3 is achieved. Figure 11 shows the detailed UMTS Turbo code encoder. The trellis termination leads each encoder into its final state separately. This dissolves the dependency between the systematic information of the first and second encoder for the tailbits, because these lead each encoder independent from the other by activating the respective switch, see figure 11. Hence the last six bits per encoder (systematic and parity for each) have to be transmitted separately. This results in a total overhead of 12 bits per block.

Decoding Turbo codes by searching the most likely codeword is far too complex. Therefore iterative decoding is advised. The two convolutional codes are decoded separately. While doing this, each decoder incorporates information that has been gathered by the other. This "gathering of information" is the exchange of soft-output values, where the bit-estimates of one unit are transformed into a priori information for the next. The decoders hence have to be soft-input soft-output (SISO) units.

The confidence in the bit estimation is represented as a Log-Likelihood-Ratio (LLR):

$$\Lambda(d_k) = \ln \frac{P(d_k = 1)}{P(d_k = 0)}$$

The sign shows whether this bit is supposed to be one or zero whereas the confidence in the decision is represented by the magnitude.

In order to extract the information that has been gathered during the last decoding stage, the systematic and a priori information that lead to this estimate have to be subtracted. This yields:

$$L^1(d_k) = \Lambda^1(d_k) - y_k^s - L_{deint}^2(d_k)$$

$$L^2(d_k) = \Lambda^2(d_k) - y_{kint}^s - L_{int}^1(d_k)$$

This is called the extrinsic information.

The confidence of one decoder in a bit to have a certain value biases the initial guess of the other.

Figure 12 shows such a Turbo code decoder consisting of two MAP decoders, an interleaver and a deinterleaver. Feeding the input of one decoder as a priori information input to the next enables the improvement over the decoding iterations. It also gave Turbo codes their name, as it resembles the "feedback-of-exhaust" used in combustion turbo engines. Inputs to the decoder are the received channel values (systematic, parity1 and parity2); during the very first MAP1 operation, the a priori information is set to zero.

Concerning the MAP algorithm, equations 2.1-2.7 are used for Turbo decoding as well as equations 2.8-2.12 and equations 3.1-3.2.

Computation of $\tilde{\gamma}$ includes the estimation of channel values and the a priori information. Whereas the conventional method is quite complicated, an optimized branch metric calculation is used. Prior to transmission, every bit is subject to a transformation. Let

$$x_k \in \{0,1\}$$

denote the (coded) bit, then the transmitted value is

$$y_k = -2 \cdot x_k + 1,$$

hence

$$y_k \in \{-1,1\}.$$

Thus the actual mapping is '1' $\rightarrow$ '-1' and '0' $\rightarrow$ '1'.

There are only four different values per k in total the $\tilde{\gamma}$ can take, one for every assumption

$$(x_k^s \in \{-1,1\}, x_k^p \in \{-1,1\}).$$

The code-structure alone determines, which of them is assigned to which transition. After skipping constant factors and making additional algebraic transformations we get :

$$\bar{\gamma}(x_k^s = +1, x_k^p = +1) = 0$$

$$\bar{\gamma}(x_k^s = +1, x_k^p = -1) = \frac{4E_s y_k^p}{N_0}$$

$$\bar{\gamma}(x_k^s = -1, x_k^p = +1) = \frac{4E_s y_k^s}{N_0} + L(d_k)$$

$$\bar{\gamma}(x_k^s = -1, x_k^p = -1) = \frac{4E_s y_k^p}{N_0} + \frac{4E_s y_k^s}{N_0} + L(d_k)$$

$$(\ 2.17\ )$$

This simplifies the implementation significantly, as only two terms have to be computed from the channel and a priori data. One term can be dropped completely and the last one be computed from the first two. The scaling factor $\frac{4E_s}{N_0}$ is multiplied externally by usage of a working point.

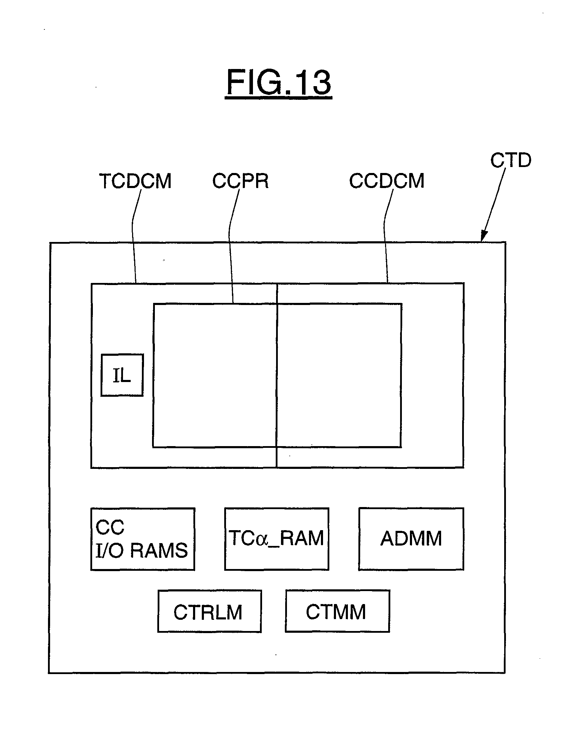

5.2 The combined decoder CTD according to this embodiment, as illustrated on figure 13, comprises Turbo-code decoding means TCDCM for performing Turbo-code decoding, and convolutional code processing means CCDCM for performing convolutional code.

Turbo-code and convolutional code decoding means comprise common processing means CCPR implementing MAP algorithm and having a first configuration dedicated to Turbo-code decoding and a second configuration dedicated to convolutional code decoding. Said common processing means CCPR or MAP unit form a Soft-in-Soft-out unit (SISO unit) on which MAP1 and MAP2 operations are done serially for turbo decoding, until a stopping criterion is fullfilled.

Further to these common processing means, the Turbo-code decoding means TCDM comprises conventional interleaving means IL.

Moreover, the combined decoder CTD comprises metrics memory means referenced as TC alpha-RAM for storing forward state metrics associated to the states of a first trellis (8 states here), said forward state metrics being delivered by the processing means CCPR in its first configuration (Turbo decoding).

Input/output memory means referenced as CC I/O RAMs are provided for storing input and output data delivered to and by the processing means CCPR in its second configuration, i.e. for CC decoding.

At last, adaptable memory means ADMM are used for storing input and output data delivered to and by said processing means CCPR in its first configuration (Turbo-code decoding), and for storing forward state metrics associated to the states of a second trellis (256 states here) and delivered by said processing means CCPR in its second configuration (convolutional code decoding).

Control means CDRLM configurate said common processing means CCPR in its first or second configuration depending on the kind of code, and memory control means CTMM address differently said adaptable memory means ADMM depending on the configuration of said common processing means CCPR.

5.3 Architecture of the common processing means CCPR

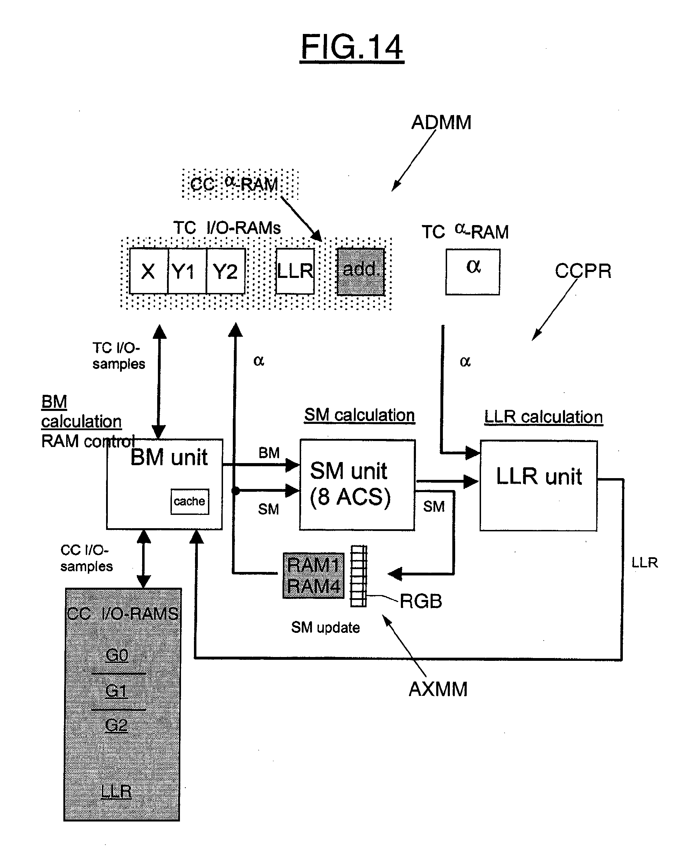

Figure 14 illustrates more in detail thus internal structures of the common processing means CCPR.

The processing means CCPR comprise essentially three major of calculation unit, i.e.,
the BM unit that calculates the branch metrics BM and controls the complete I/O RAMs and alpha RAM ;
the state metric unit which calculates 8 state metrics SM in parallel with 8 add-compare-select (ACS) units ;
the LLR unit, which calculates the LLRs in a pipelined manner.

5.4 Input/output memory means CC I/O RAMs for convolutional decoding

The input RAMs consist in three RAMs referenced as G0_RAM G1_RAM and G2_RAM according to the respective CC input data. Output RAM is CCLLR_RAM. The RAM-sizes are 512*6 bits.

5.5 Metrics memory means TC$\alpha$-RAM for Turbo decoding

The alpha state metric RAM for TC decoding is a dedicated 64*88bit RAM (alpha_RAM).

5.6 Adaptable memory means ADMM

The adaptable memory means ADMM is used either for storing input and output data for Turbo-code decoding or for storing forward state metrics in the convolutional code decoding.

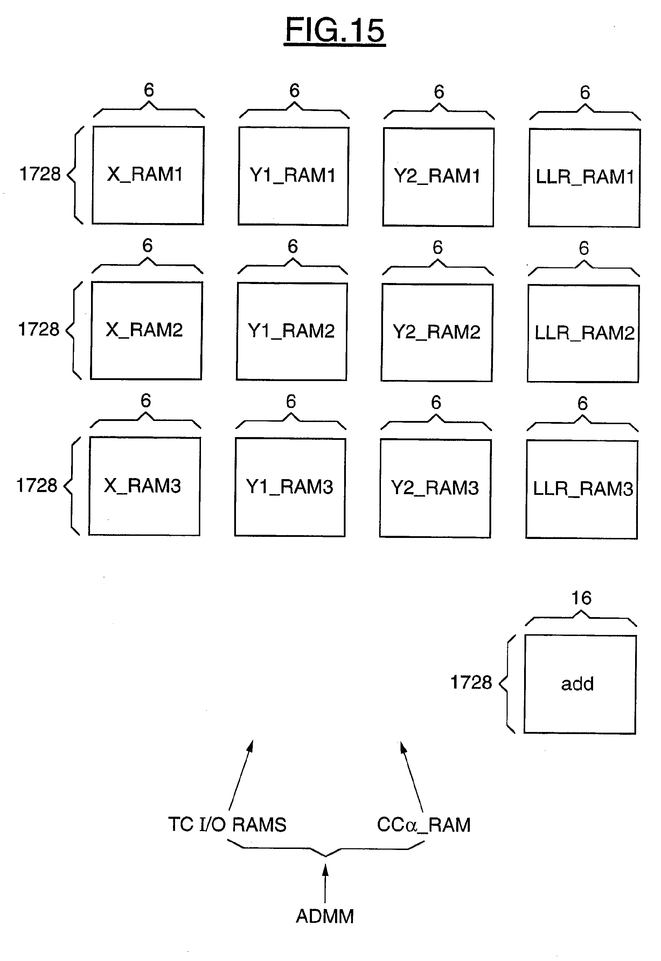

And, as shown on figure 15, these adaptable memory means comprises a lot of elementary memories as well as an additional memory means Add.

More precisely, in the present application, the Turbo-code decoding means are adapted to receive successive sequences of N1 symbols (N1=5120) of b1 bits (b1=6). The input and output data delivered to and by the processing means CCPR in its first configuration (Turbo decoding) comprises for each received sequence, g different blocs of N1 words of b1 bits. Here, g=4 and these g blocs are

the systematic input data X,
the parity input data Y1,
the interleaved parity input data Y2 and,
the decisions of the decoding, as output data.

The forward state metrics to be stored in the adaptable memory means (when convolutional code decoding) is a bloc of N2 words (N2=1728) of b2 bits, b2 being here greater than b1. Generally, the product N2 times b2 is equal to the product of W (windowsize) with the number of states of the trellis and, with the number of bits for each state. In the present case, W is equal to 54 or the convolutional code, 64 for the Turbo-code. The number of states is equal to 8 for the Turbo-code and to 256 for the convolutional code. And, the number of bits for each state is equal to 11.

Accordingly, N2 is equal to 1728 whereas b2 is equal to 88.

Thus, as shown on figure 8, the main memory means of the adaptable memory means ADDM comprises 4 groups of p (p=3) elementary memories respectively dedicated to the g blocs of N1 words. And, each elementary memory is adapted to store N2 words of b1 bits.

The additional memory Add is adapted to store 1728 words of 16 bits.

And, generally speaking, the memory control means address the adaptable memory means ADMM in said first configuration (Turbo-code decoding) such that each bloc of 5120 words of 6 bits is written in or read from its dedicated group of 3 elementary memories.

Further, said memory control means address said adaptable memory means ADMM in said second configuration (convolutional code decoding) such that the twelve elementary words of said forward state metrics are respectively stored in the twelve elementary memories of the main memory means at the same address, whereas the additional elementary word of the forward state metrics (the 16 other bits) is stored in the additional memory means at the same address.

In other words, for CC decoding each of the I/O RAMs of the TC is split into 3 separate RAMs. These RAMs are the concatenated to form the required bitwidth for the storage of 8 state metrics in parallel. We need 88 bits (8* 11 bit), the I/O RAMs are 6 bit wide so we get 4*3*6 bit=72 bit. Therefore we need an additional 16bit RAM to form the CC alpha RAM. This RAM sharing enables us to get a sufficient windowsize for CC decoding.

As shown on figure 15, the naming conventions are as follows:

The systematic input data is stored in X_RAM1, X_RAM2, X_RAM3,
the parity input data is stored in Y1_RAM1, Y1_RAM2, Y1_RAM3, and
the interleaved parity input data is stored in Y2_RAM1, Y2_RAM2, Y2_RAM3.

The TC output RAMs are LLR_RAM1, LLR_RAM2 and LLR_RAM3. The MSB represents the output hard decision, whereas the LSB represent the extrinsic information/LLR soft decision (depending on actual decoding progress). This enables a stopping of the decoding after MAP1 CRC check.

Because the RAMs are split into three, an appropriate address transformation is done to map the address space 0-5119 to three times 0-1727. This value is rounded up to the minimum feasible RAM. Only the actual needed RAMs are activated, all others are deselected.

5.7 Calculation of the branch metrics

The common processing means comprises a branch metric unit for calculating in each first and second configurations the branch metrics associated to the branches of the corresponding trellis (see eq. 2.17 for turbo code).

The transfer of TC input data samples to the CTD decoder is done in the following order :

$$X_1, Y_1^1, Y_1^2, X_2, Y_2^1, Y_2^2, ........X_{Bi}, Y_{Bi}^2, TailBits$$

$B_i$ is the number of bits in the i-th code block.

The storage of the tail bits has to be considered, the transmitted bits for the trellis termination are:

$x_{K+1}, z_{K+1}, x_{K+2}, z_{K+2}, x_{K+3}, z_{K+3}, x'_{K+1}, z'_{K+1}, x'_{K+2}, z'_{K+2}, x'_{K+3}, z'_{K+3}$; where Y1= z, Y2= z' and x'=XSecond encoder, K=block length.

The parity data RAMs Y1 and Y2 are filled sequentially, the respective three tailbits are just appended. The systematic data RAM X is also filled sequentially, because there are six tailbits in total, the tailbits for the first encoder are appended first, then the tailbits for the second encoder follow.

The input sequence for CC decoding is simpler, because there is only one tail sequence. The tailbits are just appended to the respective RAM.

The different steps of the windowing scheme can be divided into further sub-steps. The calculation of the branch metrics is the prerequisite for the calculation of the state metrics. The memory control mean therefore addresses the input RAMs to calculate the respective branch metrics. We use the optimized MAP calculation scheme proposed above. The used naming convention is based on the binary representation of the pair [systematic/parity information] $\in$\{0,1\} resp. [G0/G1], [G0/G1/G2]. X, Y, LLR, G0, G1, G2 represent the individual data stored in this RAMs (e.g. the content of the LLR-RAM is the extrinsic information).

Turbo Code:

> *branch*0 = 0
> *branch*1 = *Y*
> *branch*2 = *X + LLR*
> *branch*3 = *X + Y + LLR*

Convolutional Code, rate 1/2:

> *branch*0 = 0
> *branch*1 = *G*1
> *branch*2 = *G*0
> *branch*3 = *G*1 + *G*0

Convolutional Code, rate 1/3:

> *branch*0 = 0
> *branch*1 = *G*2
> *branch*2 = *G*1
> *branch*3 = *G*1 + *G*2
> *branch*4 = *G*0
> *branch*5 = *G*0 + *G*2
> *branch*6 = *G*0 + *G*1
> *branch*7 = *G*0 + *G*1 + *G*2

The branch metric calculation is very simple, two additions for TC and one resp. four additions (calculation of branch7 reuses a previously addition, e.g. G0+G1) for CC. In case of TC we have to use interleaved data during MAP2 operation. Therefore the BM unit interacts with the external interleaver to fetch the appropriate addresses. In order to avoid data collisions during forward and backward TC recursion, a dedicated LLR-cache is needed as well as a dedicated LLR-register.

5.8 Calculation of the state metrics

Turning now to the calculation of the state metrics, the common processing means comprises a configurable state metrics unit SM.

As shown on figures 14, 15, and 16, the configurable state metrics units SM comprises

- an architecture of 8 parallel ACS (Add, Compare, Select) units for calculating in each configuration 8 forward state metrics,
- auxiliary memory means (AXMM) for temporarily storing the calculated forward state metrics for a recursive calculation, and
- auxiliary control means for controlling the storage of the metrics in said auxiliary memory means depending on the configuration of said common processing means.

5.9 <u>ACS architecture</u>

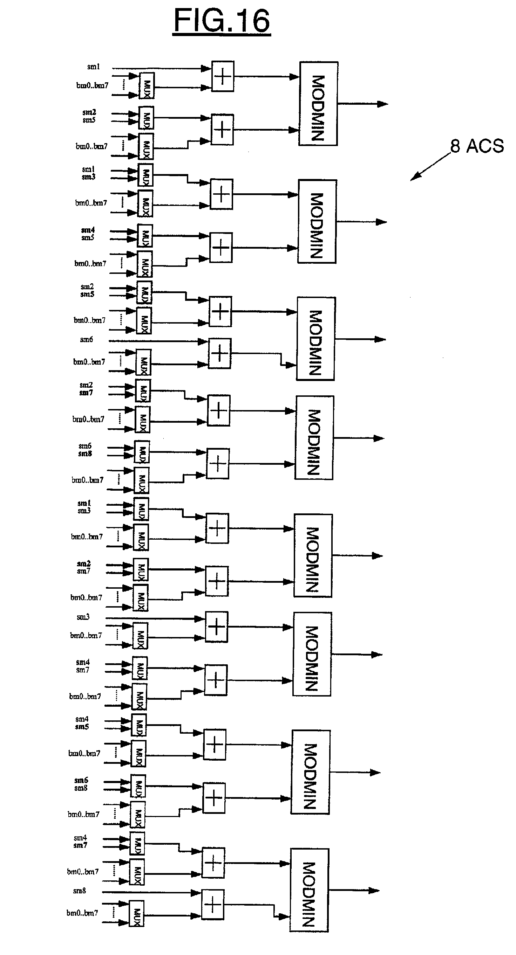

More precisely, the ACS architecture illustrated on figure 16, calculates eight state metrics in parallel out of the branch metrics and the previous state metrics according to equations 2.10 and 2.11. This is done with 8 ACS (Add, Compare, Select) units based on a modmin-procedure (the MODMIN blocs perform the min* operator).

This ACS architecture is used for forward as well as for backward recursion for both Turbo code and Convolutional code. Because of the different trellis diagrams, the flexibility is achieved with multiplexers for the incoming branch metrics (bmux) and state metrics (smux). These multiplexers are controlled externally as explained thereafter.

The eight ACS units need sixteen branch metric + state metric sums, therefore sixteen bmux multiplexers are provided. Each of these bmux multiplexers can select among eight branch metrics (because CC rate 1/3 needs eight different branch metrics in total). However, because of a particular state metric distribution not sixteen but only twelve smux state metric multiplexers are needed. Furthermore this state metric distribution leads to only 2:1 smux multiplexers, because the setting is valid for either CC forward recursion/TC backward recursion or CC backward/TC forward recursion. There is no additional multiplexing of the calculated state metrics. In case of forward recursion, the new state metrics are always in ascending order. Figure 16 shows the general architecture of the acs architecture. Sm1-sm8 denote the 8 parallel input state metrics at one timestep, bm0-bm7 denote the up to 8 different branch metrics. The smux setting for TC forward/CC backward is marked bold.The output of this unit are the new state metrics as well as the LLR-metrics ($\beta$state metric + branch metric) for the LLR calculation.

5.10 <u>Control of the multiplexers</u>

The multiplexer of the state metrics unit are controlled by a specific machine, not shown for reason of simplification.

The state metric multiplexer smux controlling is very simple. There are only two different settings, either for TC forward recursion/CC backward recursion or for TC backward recursion/CC forward recursion. The controlling of the branch metric multiplexer bmux is more complex and done in the FSM. Each sequence (32 steps) depends on the chosen rate as well as on the actual operation (forward recursion or backward recursion).

- CC rate 1/2 forward recursion
    There are 4 different sets of bmux settings, denoted A,B,C,D
    The forward sequence is
  AABBCCDDAABBCCDDCCDDAABBCCDDAABB
- CC rate 1/2 backward recursion
    There are 4 different sets of bmux settings, denoted A,B,C,D
    The backward sequence is
  AABBCCDDAABBCCDDBBAADDCCBBAADDCC
- CC rate 1/3 forward recursion
    There are 8 different sets of bmux settings, denoted
  A,B,C,D,E,F,G,H
    The forward sequence is
  ABCDEFGHFEHGBADCHGFEDCBACDABGHEF
- CC rate 1/3 backward recursion
    There are 8 different sets of bmux settings, denoted
  A,B,C,D,E,F,G,H
    The backward sequence is
  ABCDEFGHFEHGBADCDCBAHGFEGHEFCDA

5.11 The LLR unit

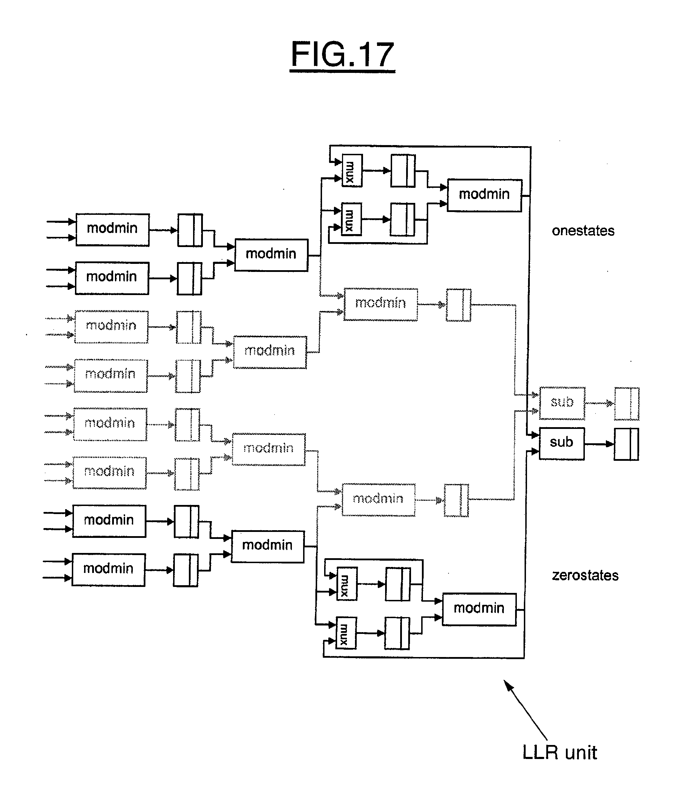

The LLR unit calculates the LLR (see eq. 2.12 for turbo code). This is done in a pipeline for the TC decoder consisting of three modmin stages with registers between stage one and stage two see Figure17. Input to the first stage are the sums alpha state metric from the alpha RAM + LLRsum (= branch metric + beta state metric) from the SM unit. This values are also registered, thus resulting in a total pipeline depth of four. The upper modmin-tree calculates the minimum of all states reached by input '1' (LLR1), the lower one the minimum reached by input '0' (LLR0).

Once the LLR calculation starts, new values are present at the inputs every clock cycle. The control is very simple and done by a simple shifting of a data valid flag through a 4 stage Flip-Flop pipeline.

Parts of the LLR calculation for TC are reused for Convolutional decoding, see figure 17 (not shown are the multiplexer for the input values and the adder for calculating the sums).

More precisely, all the architecture shown on figure 17 is used for Turbo decoding whereas only the upper and lower parts thereof are used for convolutional code decoding.

Since the encoding of the Convolutional Code is done with a NSC, the input '0' resp. '1' determines the state number.

Therefore we don't need the branch metrics, which simplifies the calculation to only four modmin units in the first stage. The upper two modmin units calculate the minimum of the four state metric sums reached by input '1' (onestates), the lower two the minimum of input '0' (zerostates). Therefore the inputs are the alpha state metrics from the alpha-RAM and the beta metrics from the AXMM memory.

Because we don't calculate all 256 states at once we need a loopback to determine the appropriate minimums. This is additional hardware compared to the Turbo decoder part and situated after stage 2. The controlling is quite simple and realized with a FSM. This can be best expressed when looking at the feedback unit for the onestates. The first minimum is stored in the lower register, the second one in the upper register. All following minima are stored in the lower register, the resulting minimum always in the upper register. The LLR_valid flag is also generated by the FSM.

5.12 Global control unit

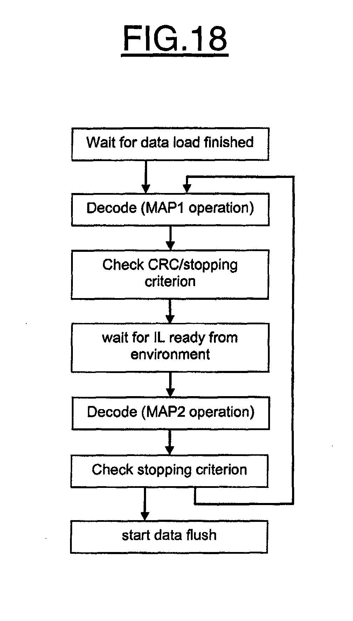

At last, the combined decoder according to the invention comprises a global control unit which controls the decoding process on MAP level. Because TC decoding is done in an iterative matter, the number of iterations depends on the actual decoding status. Therefore after each MAP operation a stopping criterion is checked. This stopping criterion can either be the selected total number of half-iterations, a correctly detected CRC-sum (only after MAP1) or an early detection of undecodable blocks based on the mean value criterion. The particular decoding steps for TC are shown in figure 18. In case of CC decoding only one MAP1 operation is needed.

Furthermore the global control unit controls the handshake mode. This handshake mode allows step-by-step execution of the decoding steps and on-demand memory flush.

**Claims**

1. Method of blindly detecting a transport format of an incident convolutional encoded signal, said transport format being ex ante unknown and belonging to a set of MF predetermined reference transport formats, said signal comprising a data block having an ex ante unknown number of bits corresponding to said ex ante unknown transport format, and a cyclic redundancy check (CRC) field containing a transmitted CRC word, said method comprising decoding said signal using a Maximum-a-Posteriori algorithm, said decoding step including decoding said signal considering respectively the MF possible reference formats and respectively delivering MF corresponding groups of soft output information, calculating from each group of soft output information a calculated CRC word and comparing said calculated CRC word with said transmitted CRC word, selecting all the groups for which said calculated CRC word is equal to said transmitted CRC word, and selecting the actual transport format of the encoded signal from at least one soft output information among the last ones of each selected group.

2. Method according to claim 1, **characterized by** the fact that said the actual transport format of the encoded signal is selected from the last soft output information of each selected group.

3. Method according to claim 2, **characterized by** the fact that the actual transport format is the reference format having the greatest last soft output information.

4. Method according to any one of the preceding claims, **characterized by** the fact that said decoding step comprises calculating states metrics, by the fact that all the data blocks are decoded in parallel window-by-window on sliding windows having a predetermined size, and by the fact that at least some of the states metrics calculated on a window are valid for all the data blocks.

5. Method according to claim 4, **characterized by** the fact that said decoding step comprises for each window calculating forward state metrics during a forward recursion, performing a backward acquisition having a predetermined acquisition length, calculating backward state metrics during a backward recursion and calculating soft output information in the reverse order, by the fact that for each window only one forward recursion is performed which is valid for all the transport formats.

6. Method according to claim 5, **characterized by** the fact that the first window processing including forward recursion, backward acquisition, backward recursion and soft output calculation, is completely valid for all data blocks having a size larger than the sum of the window size and the acquisition length.

7. Convolutional code decoder, comprising input means for receiving an convolutional encoded signal having an ex ante unknown transport format belonging to a set of MF predetermined reference transport formats, said signal comprising a data block having an ex ante unknown number of bits corresponding to said ex ante unknown transport format, and a cyclic redundancy check (CRC) field containing a transmitted CRC word, convolutional code decoding means implementing a Maximum-a-Posteriori algorithm for decoding successively said signal by considering respectively successively the MF possible reference formats and comprising a Log-Likelihood-Ratio unit for successively respectively delivering MF corresponding groups of soft output information, blind transport format detection means comprising a cyclic redundancy check unit for calculating from each group of soft output information a calculated CRC word and comparison means for comparing said calculated CRC word with said transmitted CRC word, first selection means for selecting all the groups for which said calculated CRC word is equal to said transmitted CRC word, and second selection means for selecting the actual transport format of the encoded signal from at least one soft output information among the last ones of each selected group.

8. Convolutional code decoder according to claim 7, **characterized by** the fact that said second selection means are adapted to select the actual transport format of the encoded signal from the last soft output information of each selected group.

9. Convolutional code decoder according to claim 8, **characterized by** the fact that the actual transport format is the reference format having the greatest last soft output information.

10. Convolutional code decoder according to any one of claims 7 to 9, **characterized by** the fact that said convolutional code decoding means are adapted to calculate states metrics, by the fact that all the data blocks are decoded in parallel window-by-window on sliding windows having a predetermined size, and by the fact that at least some of the states metrics calculated on a window are valid for all the data blocks.

11. Convolutional code decoder according to claim 10, **characterized by** the fact that said convolutional code decoding means are adapted for each window, to calculate forward state metrics during a forward recursion, to perform a backward acquisition having a predetermined acquisition length, to calculate backward state metrics during a backward recursion, by the fact that for each window only one forward recursion is performed which is valid for all the transport formats.

12. Convolutional code decoder according to claim 11, **characterized by** the fact that the first window processing including forward recursion, backward acquisition, backward recursion and soft output calculation, is completely valid for all data blocks having a size larger than the sum of the window size and the acquisition length.

13. Convolutional code decoder according to any one of claim 7 to 12, **characterized by** the fact it is a combined Turbo-code/convolutional code decoder further comprising Turbo-code decoding means (TCDCM) for performing turbo-code decoding.

14. Convolutional code decoder according to claim 13, **characterized by** the fact that said Turbo-code and convolutional code decoding means comprising common processing means (CCPR) having a first configuration dedicated to Turbo-code decoding and a second configuration dedicated to convolutional code decoding, and by the fact that said decoder further comprises :

-   metrics memory means (TC$\alpha$-RAM) for storing state metrics associated to the states of a first trellis and delivered by said processing means in its first configuration,

- input/output memory means (CC I/O RAMs) for storing input and output data delivered to and by said processing means in its second configuration,
- adaptable memory means (ADMM) for storing input and output data delivered to and by said processing means in its first configuration, and for storing state metrics associated to the states of a second trellis and delivered by said processing means in its second configuration,
- control means (CTRLM) for configurating said common processing means in its first or second configuration depending on the kind of code, and
- memory control means (CTMM) for addressing differently said adaptable memory means depending on the configuration of said common processing means.

15. Convolutional code decoder according to any one of claims 7 to 14, **characterized by** the fact that said common processing means (CCPR) implements a Maximum-A-Posteriori (MAP) algorithm.

16. Convolutional code decoder according to claim 15, **characterized by** the fact that the MAP algorithm implemented is a so-called LogMAP algorithm or a so-called MaxLogMAP algorithm.

17. Convolutional code decoder according to any one of claims 7 to 16, **characterized by** the fact it is realized by an integrated circuit.

18. Terminal of a wireless communication system, including a decoder according to any one of claims 7 to 17.

19. Terminal according to claim 18, **characterized by** the fact it forms a cellular phone.

20. Terminal according to claim 18, **characterized by** the fact it forms a base station.

# FIG.1

Input

Output 0
$G_0 = 561$

Output 1
$G_1 = 753$

(a) Rate 1/2 convolutional encoder

Input

Output 0
$G_0 = 557$

Output 1
$G_1 = 663$

Output 2
$G_2 = 711$

(b) Rate 1/3 convolutional encoder

# FIG.2

# FIG.3

# FIG.4

CTD

CCDCM

CC
I/O RAMS

CCα_RAM

BTFD

# FIG.5

CCDCM

CC I/O-RAMs

| G0 | G1 | G2 |

LLR

CC α-RAM

α

CC I/O-
samples

α

α

BM
calculation
RAM control

SM calculation

LLR calculation

BM unit

BM

SM unit

LLR unit

SM

SM

LLR

temp
RAM

SM update

# FIG.6

$n_1$  $n_2$  $n_m$  $n_{MF}$

TF$_1$ | data bits | CRC | DTX

$n_1$  $n_2$  $n_m$  $n_{MF}$

TF$_2$ | data bits | CRC | DTX

$n_1$  $n_2$  $n_m$  $n_{MF}$

TF$_{MF}$ | data bits | CRC

# FIG.7

CRCU

BCRCi

CRC length    CRC polynomial

block length

LLR bits

CRC generator

controller

CRG1

CRC register

DEMUX

BFF

buffer

CRC_okay

= ?

CRC sum

CRG2

# FIG.8

wait for crc_w_finished

| fwd | acq | bwd/ LLR | fwd | acq | bwd/ LLR | fwd | acq | bwd/ LLR | fwd | acq | bwd/ LLR | fwd |

1st window | 2nd window | 3rd window | last window | time

shift CRC bits into buffer

shift CRC bits out of buffer

EP 1 471 677 A1

# FIG.9

# FIG.10

Detected = 0
$i_{min}$ = 1
M = 0
D = 0
BC = $n_{max}$
WC = 0
$LLR_{max}(end)$ = 0

ws = window size
al = acquisition length
$n_i$ = block length
$i_{max}$ = max number of blocks

START

BC > ws ?

yes → WC = ws

no → WC = BC

END

forward (WC)

Decode detected

$i = i_{min}$

Detected ?

no

yes

D = $n_i$ - M

$i_{min} = i_{min} + 1$

D = ?

D > ws + al

$ws \leq D \leq ws + al$

D < ws

100

101

102

acquisition (al)
backward/
LLR (ws)
shift (i, ... $i_{max}$)
BC = BC - ws
M = M + ws

tailing
acquisition (D-ws)
backward/
LLR (ws)
shift (i)
i = i + 1

tailing

backward/
LLR (D)
shift (i)

$i = i_{max}$ ?

no

yes

CRC check

not okay

okay

Compare $LLR_i(end)$

$LLR_i(end) > LLR_{max}(end)$

$LLR_{max}(end) = LLR_i(end)$
Detected = i

29

# FIG.11

systematic₁

1st RSC encoder        parity₁

Input

Input
Interleaver
Output

Output

2nd RSC encoder        parity₂

systematic₂

# FIG.12

$\vec{L}^2_{de\,int}$    DIL

$\vec{L}$    IL

$\vec{\Lambda}^1$    —

MAP1    $-$

$\vec{y}^{p1}$

$\vec{y}^s$        IL

$\vec{y}^s_{int}$

$\vec{y}^{p2}$    MAP2    $-$    $\vec{L}^2$

$-$

DIL    $\vec{\Lambda}^2$

# FIG.13

TCDCM    CCPR       CCDCM       CTD

IL

CC
I/O RAMS          TCα_RAM          ADMM

CTRLM          CTMM

# FIG.14

ADMM

CC α-RAM

TC I/O-RAMs

| X | Y1 | Y2 |  LLR  | add. |

TC α-RAM

| α |

CCPR

TC I/O-samples

α

α

**BM calculation RAM control**

SM calculation

LLR calculation

BM unit

cache

BM

SM

SM unit (8 ACS)

SM

LLR unit

CC I/O-samples

RAM1 RAM4

RGB

LLR

CC I/O-RAMS

G0

G1

G2

LLR

SM update

AXMM

# FIG.15

| 6 | 6 | 6 | 6 |

1728 { X_RAM1 | Y1_RAM1 | Y2_RAM1 | LLR_RAM1

| 6 | 6 | 6 | 6 |

1728 { X_RAM2 | Y1_RAM2 | Y2_RAM2 | LLR_RAM2

| 6 | 6 | 6 | 6 |

1728 { X_RAM3 | Y1_RAM3 | Y2_RAM3 | LLR_RAM3

16

1728 { add

TC I/O RAMS          CCα_RAM

ADMM

# FIG.16

8 ACS

# FIG.17

onestates

zerostates

LLR unit

# FIG.18

```
┌─────────────────────────────┐
│  Wait for data load finished │
└─────────────────────────────┘
              │
              ▼
┌─────────────────────────────┐
│   Decode (MAP1 operation)    │◄──────┐
└─────────────────────────────┘       │
              │                        │
              ▼                        │
┌─────────────────────────────┐       │
│      Check CRC/stopping      │       │
│          criterion           │       │
└─────────────────────────────┘       │
              │                        │
              ▼                        │
┌─────────────────────────────┐       │
│     wait for IL ready from   │       │
│         environment          │       │
└─────────────────────────────┘       │
              │                        │
              ▼                        │
┌─────────────────────────────┐       │
│   Decode (MAP2 operation)    │       │
└─────────────────────────────┘       │
              │                        │
              ▼                        │
┌─────────────────────────────┐       │
│   Check stopping criterion   │───────┘
└─────────────────────────────┘
              │
              ▼
┌─────────────────────────────┐
│      start data flush        │
└─────────────────────────────┘
```

European Patent
Office

**EUROPEAN SEARCH REPORT**

Application Number

EP 03 29 0993

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | US 2002/108090 A1 (AMRANI OFER ET AL) 8 August 2002 (2002-08-08) * abstract * * paragraphs [0020]-[0025] * * paragraphs [0011],[0012],[0014],[0021] * --- | 1-3,7-9 | H04L1/00 H03M13/29 |
| Y | EP 1 207 659 A (NTT DOCOMO INC) 22 May 2002 (2002-05-22) * paragraphs [0004],[0008],[0009] * * figures 8,9 * * paragraph [0076] * * paragraphs [0059]-[0063] * | 1-3,7-9 | |
| Y | * figure 8 * | 13-20 | |
| Y | * paragraph [0076] * | 4,5,10, 11 | |
| Y | WO 02 07453 A (MOTOROLA INC) 24 January 2002 (2002-01-24) * the whole document * --- | 4,5,10, 11 | |
| Y | EP 1 204 210 A (LUCENT TECHNOLOGIES INC) 8 May 2002 (2002-05-08) * abstract * * tables 1,2 * * paragraphs [0014],[0037],[0040],[0045] * * paragraph [0065] * * claims 1-4,6,9 * --- | 13-20 | TECHNICAL FIELDS SEARCHED (Int.Cl.7) H04L H03M |
| A | PIETROBON S S: "IMPLEMENTATION AND PERFORMANCE OF A TURBO/MAP DECODER" INTERNATIONAL JOURNAL OF SATELLITE COMMUNICATIONS, JOHN WILEY AND SONS, US, vol. 16, no. 1, 1998, pages 23-46, XP000856961 ISSN: 0737-2884 * the whole document * --- | 1-22 | |

-/--

The present search report has been drawn up for all claims

| Place of search | Date of completion of the search | Examiner |
|---|---|---|
| THE HAGUE | 17 September 2003 | Rydyger, K |

**European Patent Office**

## EUROPEAN SEARCH REPORT

Application Number

EP 03 29 0993

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 2001/046269 A1 (LAINE ARMELLE ET AL) 29 November 2001 (2001-11-29) <br> * paragraph [0016] * <br> * paragraph [0042] * <br> ----- | 4,5,11, 12 | |
| | | | **TECHNICAL FIELDS SEARCHED** (Int.Cl.7) |

The present search report has been drawn up for all claims

| Place of search | Date of completion of the search | Examiner |
|---|---|---|
| THE HAGUE | 17 September 2003 | Rydyger, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 03 29 0993

This annex lists the patent family members relating to the patent documents cited in the above-mentioned European search report.
The members are as contained in the European Patent Office EDP file on
The European Patent Office is in no way liable for these particulars which are merely given for the purpose of information.

17-09-2003

| Patent document cited in search report | | Publication date | Patent family member(s) | | Publication date |
|---|---|---|---|---|---|
| US 2002108090 | A1 | 08-08-2002 | WO | 02063889 A2 | 15-08-2002 |
| EP 1207659 | A | 22-05-2002 | JP | 2002158642 A | 31-05-2002 |
| | | | CN | 1354574 A | 19-06-2002 |
| | | | EP | 1207659 A2 | 22-05-2002 |
| | | | US | 2002075964 A1 | 20-06-2002 |
| WO 0207453 | A | 24-01-2002 | AU | 7352001 A | 30-01-2002 |
| | | | WO | 0207453 A2 | 24-01-2002 |
| EP 1204210 | A | 08-05-2002 | US | 2002129317 A1 | 12-09-2002 |
| | | | EP | 1204210 A1 | 08-05-2002 |
| | | | EP | 1204211 A1 | 08-05-2002 |
| | | | EP | 1204212 A1 | 08-05-2002 |
| | | | JP | 2002171173 A | 14-06-2002 |
| | | | JP | 2002176366 A | 21-06-2002 |
| | | | JP | 2002152057 A | 24-05-2002 |
| | | | US | 2002129320 A1 | 12-09-2002 |
| | | | US | 2002162074 A1 | 31-10-2002 |
| US 2001046269 | A1 | 29-11-2001 | EP | 1122890 A2 | 08-08-2001 |
| | | | JP | 2001267938 A | 28-09-2001 |

EPO FORM P0459

For more details about this annex : see Official Journal of the European Patent Office, No. 12/82